# EUROPÄISCHE PATENTSCHRIFT

(11) **EP 0 894 295 B1**
(45) Veröffentlichungstag und Bekanntmachung des Hinweises auf die Patenterteilung: **19.01.2000**
(21) Anmeldenummer: 97915307.9
(22) Anmeldetag: 27.02.1997
(51) Int. Cl.: G05B 19/05, F02D 41/24

(54) **VERFAHREN ZUR AUTOMATISCHEN DOKUMENTATION DES PROGRAMMIERVORGANGS DES SPEICHERS EINES PROGRAMMIERBAREN STEUERGERÄTES**
PROCESS FOR AUTOMATIC DOCUMENTATION OF THE OPERATION OF PROGRAMMING THE MEMORY OF A PROGRAMMABLE CONTROLLER
PROCEDE POUR LA DOCUMENTATION AUTOMATIQUE DU PROCESSUS DE PROGRAMMATION DE LA MEMOIRE D'UN APPAREIL DE COMMANDE PROGRAMMABLE

(30) Priorität: 17.04.1996 DE 19615105
(43) Veröffentlichungstag der Anmeldung: 03.02.1999
(73) Patentinhaber: ROBERT BOSCH GMBH, 70442 Stuttgart (DE)
(72) Erfinder: FACKLER, Rupert, D-74385 Pleidelsheim (DE)
(86) Internationale Anmeldenummer: DE9700343
(87) Internationale Veröffentlichungsnummer: WO9739391

(56) Entgegenhaltungen:
- EP-A- 0 664 387
- DE-A- 4 332 499
- IBM TECHNICAL DISCLOSURE BULLETIN, Bd. 34, Nr. 1, 1.Juni 1991, Seiten 50-51, XP000210108 "OBJECT-ORIENTED DOCUMENTATION TOOL"

## Beschreibung

### Stand der Technik

Die vorliegende Erfindung betrifft ein Verfahren gemäß dem Oberbegriff des Patentanspruchs 1, d.h. ein Verfahren zum Betreiben eines Steuergerätes mit einer programmierbaren Speichereinrichtung zum Speichern von Daten und Programmen für den Betrieb des Steuergerätes.

Ein derartiges Verfahren ist beispielsweise in der DE 43 32 499 A1 offenbart. Das in dieser Druckschrift beschriebene Steuergerät ist ein Kraftfahrzeugsteuergerät, das zum Speichern von Daten und Programmen für den Betrieb des Gerätes mit programmierbaren, genauer gesagt löschbaren nichtflüchtigen Speichereinrichtungen in Form von Flash-EPROMs ausgerüstet ist.

Das Vorsehen einer programmierbaren Speichereinrichtung als Speichereinrichtung zum Speichern von Daten und Programmen für den Betrieb des Steuergerätes erweist sich als vorteilhaft, weil dadurch der Betrieb des Steuergerätes auf einfache Weise jederzeit dauerhaft veränderbar ist, was insbesondere bei anfangs nicht erkannten Fehlern in den gespeicherten Daten und Programmen oder bei individuellen Kundenwünschen von nicht unerheblicher Bedeutung ist.

Die Verwendung von Flash-EPROMs als programmierbare Speichereinrichtungen gewinnt dabei zunehmend an Bedeutung, weil diese die Vorzüge eines "normalen" EPROM (hohe Speicherzellendichte auf engem Raum) und eines EEPROM (elektrisches und damit einfaches und bequemes Löschen des Speicherinhalts) in sich vereinen.

Zum anfänglichen Programmieren, d.h. Löschen und/oder Überschreiben der Flash-EPROMs (vorzugsweise in Abhängigkeit vom Kraftfahrzeug-Typ im Kraftfahrzeug-Herstellungsbetrieb) oder zur späteren Umprogrammierung derselben (beim Kundendienst zur Fehlerbeseitigung oder entsprechend individuellen Kundenwünschen) wird ein externes Programmiergerät, beispielsweise in Form eines Personal Computers an das Steuergerät angeschlossen. Durch ein derartiges Programmiergerät wird bei Bedarf das Ausführen von im Steuergerät gespeicherten Steuerprogrammen zum Löschen und/oder Überschreiben von Daten im Flash-EPROM veranlaßt und gegebenenfalls die neu einzuspeichernden Daten zur Verfügung gestellt.

Eine derart einfache und schnell durchführbare Programmierbarkeit der Speichereinrichtung zum Speichern von Daten und Programmen für den Betrieb des Steuergerätes eröffnet die Möglichkeit, daß das Steuergerät sehr flexibel einsetzbar und dabei einfach und schnell an die jeweiligen Gegebenheiten anpaßbar ist.

Andererseits liegt in der Überschreibbarkeit bzw. Löschbarkeit des Inhalts der Speichereinrichtung auch eine gewisse Gefahr, denn Veränderungen des Speicherinhalts, und zwar insbesondere Veränderungen infolge von Störungen oder Fehlprogrammierungen können unter Umständen zu einem nicht unerheblichen Sicherheitsrisiko führen.

Aus diesem Grund ist es unter anderem erforderlich, erkannte Störungen im Steuer- und/oder Programmiergerät möglichst umgehend zu beseitigen. Die Suche nach der Ursache einer vermeintlichen Störung macht jedoch nur dann Sinn, wenn feststeht, daß die Speicherinhaltsveränderung tatsächlich auch auf eine Störung zurückgeht.

Der vorliegenden Erfindung liegt daher die Aufgabe zugrunde, nach geeigneten Maßnahmen zu suchen, die es erlauben, die Ursache für einen nicht bestimmungsgemäßen Inhalt der programmierbaren Speichereinrichtung zu ermitteln.

Diese Aufgabe wird erfindungsgemäß durch die im kennzeichnenden Teil des Patentanspruchs 1 beanspruchten Merkmale gelöst.

Demnach ist vorgesehen, daß einhergehend mit der Programmierung der programmierbaren Speichereinrichtung den Programmiervorgang dokumentierende Daten gespeichert werden.

Bei entsprechender Auswahl der einen jeweiligen Programmiervorgang dokumentierenden Daten und Speicherung derselben in einen nichtflüchtigen Speicher können aus diesen jederzeit mehr oder weniger detaillierte Aussagen über gegebenenfalls vorgenommene Umprogrammierungen der programmierbaren Speichereinrichtung gemacht werden.

Je umfassender die zur Dokumentierung jeweiliger Programmiervorgänge ausgewählten Daten sind, desto präziser läßt sich eine spätere Rekonstruktion des betreffenden Programmiervorganges bewerkstelligen.

Die zur Dokumentierung jeweiliger Programmiervorgänge ausgewählten Daten können beispielsweise Informationen beinhalten
- über den Zeitpunkt, den Ablauf, die Dauer und/oder den Erfolg jeweiliger Programmiervorgänge,
- über die Position (innerhalb der Speichereinrichtung), den Umfang, die Art (Löschen und/oder Überschreiben) und/oder den Inhalt (z.B. Checksummen neu eingeschriebener Daten und dergleichen) jeweils vorgenommener Veränderungen, und/oder
- über das den jeweiligen Programmiervorgang veranlassende Programmiergerät.

Unter Auswertung derartiger Informationen kann unter anderem ermittelt werden, ob und in welchem Umfang jeweilige Bereiche der programmierbaren Speichereinrichtung Datenveränderungen durch Umprogrammierungen unterworfen wurden.

Liegt eine zu untersuchende Datenveränderung außerhalb von durch Umprogrammierungen veränderten Bereichen oder handelt es sich um eine Veränderung, die so durch die Umprogrammierung nicht vorgenommen worden war, leiden das Steuer- und/oder das Programmiergerät an einer Störung, die es zu beheben gilt.

Dadurch ist es möglich, zuverlässig die Ursache für einen nicht bestimmungsgemäßen Inhalt der programmierbaren Speichereinrichtung zu ermitteln.

Die Ermittlung der Ursache ist nach einem festen Schema durchführbar, das es erlaubt, einen automatischen Selbsttest nach gegebenenfalls zu behebenden Störungen durchzuführen.

Neben der sicheren Erkennung von Störungen ermöglicht das erfindungsgemäße Verfahren darüber hinaus auch die Feststellung, ob es sich bei einer vorgenommenen Umprogrammierung der programmierbaren Speichereinrichtung um eine bestimmungsgemäße Programmierung durch eine hierzu autorisierte Stelle oder eine (versehentliche oder mißbräuchliche) Programmierung durch einen unbefugten handelt.

Vorteilhafte Weiterbildungen der Erfindung sind Gegenstand der Unteransprüche.

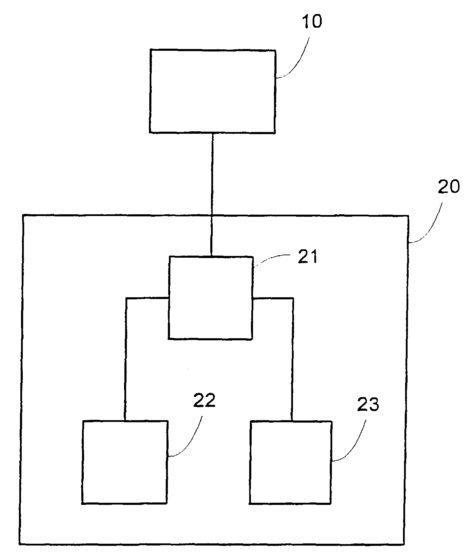

Die Erfindung wird nachfolgend anhand eines Ausführungsbeispiels unter Bezugnahme auf die Zeichnung näher erläutert.

Die Figur zeigt ein mit einem externen Programmiergerät verbundenes Steuergerät, das die Durchführung des erfindungsgemäßen Verfahrens gestattet.

Die nachstehenden Erläuterungen betreffen ein Verfahren zum Betreiben eines Steuergerätes, insbesondere eines Steuergerätes zur Steuerung beispielsweise des Motors, des Getriebes, der Bremsen etc. eines Kraftfahrzeuges, also eines Kraftfahrzeugsteuergerätes.

Das Steuergerät enthält zum Speichern von Daten und Programmen für dessen Betrieb programmierbare Speichereinrichtungen, genauer gesagt löschbare nichtflüchtige Speichereinrichtungen in Form von Flash-EPROMs, deren besondere Vorzüge für diesen Anwendungsbereich bereits eingangs erwähnt wurden.

Die Programmierung der Speichereinrichtungen erfolgt über ein externes Programmiergerät, das beispielsweise über eine serielle Schnittstelle mit dem Kraftfahrzeugsteuergerät verbindbar ist.

Die vorliegende Erfindung ist jedoch nicht auf die Programmierung von Flash-EPROMs in Kraftfahrzeugsteuergeräten unter Verwendung eines externen Programmiergerätes beschränkt. Sie ist vielmehr überall dort anwendbar, wo es ganz allgemein darum geht, eine Speichereinrichtung eines Steuergerätes durch eine Programmiervorrichtung zu programmieren.

Das Steuergerät ist in der Figur mit dem Bezugszeichen 20 bezeichnet. Es enthält eine Steuereinheit 21, eine erste programmierbare Speichereinrichtung 22 und eine zweite programmierbare Speichereinrichtung 23.

Die Steuereinheit 21 ist durch einen Mikrocomputer, Mikrocontroller oder dergleichen realisiert; sie arbeitet zur Ausübung der ihr zugeteilten Steuerfunktion und zur Selbststeuerung Programme ab, die zusammen mit gegebenenfalls zu deren Ausführung benötigten Daten in der ersten Speichereinrichtung 22 gespeichert sind.

Die erste Speichereinrichtung 22 ist eine programmierbare Speichereinrichtung, genauer gesagt eine löschbare nichtflüchtige Speichereinrichtung in Form eines Flash-EPROM.

Die zweite Speichereinrichtung 23 ist ebenfalls eine programmierbare Speichereinrichtung, genauer gesagt wiederum eine löschbare nichtflüchtige Speichereinrichtung, die jedoch im vorliegenden Ausführungsbeispiel durch ein EEPROM realisiert ist. Diese zweite Speichereinrichtung 23 dient zum Speichern von nachfolgend noch näher beschriebenen Programmierungsdokumentationsdaten.

Die erste Speichereinrichtung 22 wird auf Veranlassung und unter Mitwirkung eines externen Programmiergerätes 10, vorzugsweise in Form eines Personal Computers oder dergleichen, programmiert.

Das Programmiergerät 10 ist mit dem Steuergerät 20 über eine serielle Schnittstelle verbunden. Gibt das Programmiergerät 10 eine Programmieranforderung an das Steuergerät 20 aus, veranlaßt das Steuergerät (zumindest sofern es sich um einen bestimmungsgemäßen Programmierversuch handelt) das Löschen von in der ersten Speichereinrichtung 22 gespeicherten Daten und/oder das Einschreiben neuer, in der Regel vom Programmiergerät 10 übertragener Daten in die erste Speichereinrichtung 22.

Einhergehend mit der Programmierung der ersten Speichereinrichtung 22, d.h. vor, während und/oder nach dem Löschen und/oder Überschreiben der ersten Speichereinrichtung 22 wird dieser Vorgang durch Einspeichern der vorstehend bereits erwähnten Programmierungsdokumentationsdaten in die zweite Speichereinrichtung 23 dokumentiert; dem Einspeichern der Programmierungsdokumentationsdaten in die zweite Speichereinrichtung 23 bereits bzw. noch während des Programmierens der ersten Speichereinrichtung 22 ist dabei der Vorzug zu geben, weil durch eine derartige zeitliche Verschachtelung der Einspeicherung von Daten in die erste und die zweite Speichereinrichtung die wenigsten Möglichkeiten gegeben sind, ein Umprogrammieren der ersten Speichereinrichtung 22 ohne Dokumentation desselben durch Einschreiben von Programmierungsdokumentationsdaten in die zweite Speichereinrichtung 23 vorzunehmen.

Bei entsprechender Festlegung von Art und Umfang der Programmierungsdokumentationsdaten können später aus diesen jederzeit mehr oder weniger detaillierte Aussagen über gegebenenfalls vorgenommene Umprogrammierungen der ersten Speichereinrichtung 22 gemacht werden.

Je umfassender die Programmierungsdokumentationsdaten sind, desto präziser läßt sich eine spätere Rekonstruktion des dadurch dokumentierten Programmiervorganges bewerkstelligen.

Die zur Dokumentierung jeweiliger Programmiervorgänge ausgewählten Programmierungsdokumentationsdaten können unter anderem beispielsweise Informationen beinhalten
- über den Zeitpunkt, den Ablauf, die Dauer und/oder den Erfolg jeweiliger Programmiervorgänge,
- über die Position (innerhalb der ersten Speichereinrichtung), den Umfang, die Art (Löschen und/oder Überschreiben) und/oder den Inhalt (z.B. Checksummen neu eingeschriebener Daten und dergleichen) jeweils vorgenommener Veränderungen, und/oder
- über das den jeweiligen Programmiervorgang veranlassende Programmiergerät.

Beim vorliegenden Ausführungsbeispiel sind es beispielsweise das Datum, eine Kennung des Programmiergerätes, relevante Status- und/oder Fehlerinformationen von Steuergerät und/oder Programmiergerät während der Programmierung der ersten Speichereinrichtung 22 und Checksummen von neu in die erste Speichereinrichtung 22 eingeschriebenen Daten, die als Programmierungsdokumentationsdaten in die zweite Speichereinrichtung 23 gespeichert werden.

Bei den in Form von Programmierungsdokumentationsdaten speicherbaren Informationen besteht jedoch keine Einschränkung auf die vorstehend genannten Informationen. Die Programmierungsdokumentationsdaten können vielmehr jegliche Information repräsentieren, die - auf welche Art auch immer - Aufschlüsse über erfolgte Programmierungen oder Umprogrammierungen der ersten Speichereinrichtung 22 geben kann.

Die Veranlassung des Einspeicherns der genannten Programmierungsdokumentationsdaten in die zweite Speichereinrichtung 23 kann grundsätzlich sowohl durch das Programmiergerät 10 als auch durch das Steuergerät 20 erfolgen.

Um zu verhindern, daß mißbräuchliche Umprogrammierungen der ersten Speichereinrichtung 22 oder Umprogrammierungen derselben durch unbefugte Dritte vertuscht werden können, ist jedoch die Variante vorzuziehen, daß das Einspeichern der Programmierungsdokumentationsdaten in die zweite Speichereinrichtung 23 ohne Anstoß durch das Programmiergerät 10 völlig selbständig und automatisch durch das Steuergerät 20 erfolgt. Aus dem genannten Grund kann es sich auch als vorteilhaft erweisen, wenn das Löschen und/oder Beschreiben der zweiten Speichereinrichtung 23 und eine Veranlassung desselben durch eine externe Vorrichtung wie das Programmiergerät 10 explizit ausgeschlossen ist, so daß in der zweiten Speichereinrichtung 23 gespeicherte Inhalte nicht ohne weiteres beseitigt werden können.

Die zweite Speichereinrichtung 23 wird beim vorliegenden Ausführungsbeispiel durch das Steuergerät 20 automatisch zu Beginn des Programmierens der ersten Speichereinrichtung 22 (beispielsweise bei Erhalt der Programmieranforderung durch das Programmiergerät) geöffnet und bei Beendigung des Programmierens der ersten Speichereinrichtung 22 geschlossen.

Die Speicherkapazität der zweiten Speichereinrichtung 23 ist vorzugsweise ausreichend groß bemessen, um eine Vielzahl von die erste Speichereinrichtung betreffenden Programmierungsvorgängen, beispielsweise zehn Programmierungsvorgänge dokumentieren zu können.

Aufgrund der Tatsache, daß in die zweite Speichereinrichtung 23 nicht etwa die schon in die erste Speichereinrichtung 22 einzuschreibenden bzw. eingeschriebenen Daten, sondern lediglich den Speichervorgang als solchen dokumentierende Daten aufzunehmen sind, ist die in die zweite Speichereinrichtung 23 einzuspeichernde Datenmenge relativ gering, so daß selbst bei Vorsehen einer für mehrere Programmierungsvorgänge ausreichenden Speicherkapazität eine relativ geringe Speicherkapazität ausreichend ist. Aus diesem Grund kann hierfür eine Speichereinrichtung verwendet werden, die wie EEPROMs eine relativ geringe Speicherzellendichte aufweisen. Selbstverständlich können für die zweite Speichereinrichtung 23 wie auch für die erste Speichereinrichtung 22 ebenfalls Flash-EPROMs eingesetzt werden. Die erste und die zweite Speichereinrichtung können auch durch ein einziges Flash-EPROM gebildet werden, wobei dann jedoch aufgrund der wie vorstehend bereits beschriebenen völlig unterschiedlichen Ansteuerung unter Umständen ein etwas höherer Steuerungsaufwand in Kauf zu nehmen ist.

Um den Steuerungsaufwand, insbesondere die Adreßverwaltung für die Ansteuerung der zweiten Speichereinrichtung 23 gering zu halten, ist entweder ein für die zweite Speichereinrichtung vorgesehener Adreßzähler derart ausgebildet, daß er ohne fortlaufendes Überprüfen bei Erreichen des Speicherendes automatisch auf den Speicheranfang zurückspringt (Modulo-Zähler), oder ist die zweite Speichereinrichtung 23 als Ringspeicher ausgebildet.

Der Inhalt der zweiten Speichereinrichtung 23 kann bei Bedarf über die serielle Schnittstelle ausgelesen werde, über welche auch das Programmiergerät 10 mit dem Steuergerät 20 verbunden ist.

Die aus der zweiten Speichereinrichtung 23 ausgelesenen oder gegebenenfalls auch intern im Steuergerät auswertbaren Informationen dokumentieren die letzten Programmiervorgänge der ersten Speichereinrichtung 22.

Anhand dieser Informationen läßt sich ermitteln, auf welche Weise ursprünglich in der ersten Speichereinrichtung 22 nicht vorhandene Daten dort hin gelangt sind, genauer gesagt ob ursprünglich in der ersten Speichereinrichtung 22 nicht vorhandene Daten durch eine Umprogrammierung der ersten Speichereinrichtung 22 oder anderweitig, insbesondere infolge einer Störung dort hin gelangt sind.

Ferner kann unter Umständen (beispielsweise unter Auswertung einer gespeicherten Programmiergeräte-Kennung oder dergleichen) festgestellt werden, ob eine gegebenenfalls vorgenommene Umprogrammierung der ersten Speichereinrichtung 22 durch eine hierzu befugte Stelle oder Person vorgenommen wurde oder nicht.

Die Feststellungen, die sich aus den in der zweiten Speichereinrichtung 23 gespeicherten Programmierungsdokumentationsdaten treffen lassen, sind aus mehreren Gründen von großer Bedeutung.

Einerseits kann schnell und fehlerfrei entschieden werden, ob das Steuergerät aufgrund aufgetretener Störungen auszutauschen oder zu reparieren ist.

Anderseits kann einem Benutzer eine unbefugte Fehl- bzw. Umprogrammierung nachgewiesen werden, die gegebenenfalls zu einem Wegfall von Garantie- und Haftungsansprüchen führen kann.

Ferner kann durch die Verfolgbarkeit der Umprogrammierungen der ersten Speichereinrichtung 22 ermittelt werden, ob ein Defekt oder vorzeitiger Verschleiß von Komponenten des durch das Steuergerät zu steuernden Kraftfahrzeugs oder dergleichen auf einem Mangel der betroffenen Komponente oder auf einer nicht ordnungsgemäßen Ansteuerung durch das Steuergerät beruht.

## Patentansprüche

1. Verfahren zum Betreiben eines Steuergerätes (20) mit einer ersten programmierbaren Speichereinrichtung (22) zum Speichern von Daten und Programmen für den Betrieb des Steuergerätes und mit einer zweiten nichtflüchtigen Speichereinrichtung (23), wobei einhergehend mit der Programmierung der ersten Speichereinrichtung (22) Daten, die den Programmiervorgang dokumentieren, in die zweite Speichereinrichtung (23) gespeichert werden, dadurch gekennzeichnet, daß das Löschen und/oder Beschreiben der zweiten Speichereinrichtung (23) oder eine Veranlassung des Löschens und/oder des Beschreibens der zweiten Speichereinrichtung (23) durch eine externe Vorrichtung ausgeschlossen ist.

2. Verfahren nach Anspruch 1 dadurch gekennzeichnet, daß die Speicherung der den Programmiervorgang dokumentierenden Daten unter selbständiger und ausschließlicher Veranlassung durch das Steuergerät (20) begonnen und beendet wird.

3. Verfahren nach Anspruch 1, dadurch gekennzeichnet, daß die Speicherung der den Programmiervorgang dokumentierenden Daten während der Programmierung der programmierbaren Speichereinrichtung (22) erfolgt.

4. Verfahren nach Anspruch 1, dadurch gekennzeichnet, daß die Speicherung der den Programmiervorgang dokumentierenden Daten während des Löschens oder während des Überschreibens der ersten Speichereinrichtung (22) erfolgt.

5. Verfahren nach Anspruch 1, dadurch gekennzeichnet, daß die zweite Speichereinrichtung (23) für die den Programmiervorgang dokumentierenden Daten als Ringspeicher ausgebildet ist.

6. Verfahren nach Anspruch 5, dadurch gekennzeichnet, daß ein der zweiten Speichereinrichtung (23) für die den Programmiervorgang dokumentierenden Daten zugeordneter Adreßzähler als Modulo-Zähler ausgebildet ist.

7. Vorrichtung zum Betreiben eines Steuergerätes (20) mit einer ersten programmierbaren Speichereinrichtung (22) zum Speichern von Daten und Programmen für den Betrieb des Steuergerätes und mit einer zweiten nichtflüchtigen Speichereinrichtung (23), wobei einhergehend mit der Programmierung der programmierbaren Speichereinrichtung Daten, die den Programmiervorgang dokumentieren, in die zweite Speichereinrichtung (23) gespeichert werden, dadurch gekennzeichnet, daß das Löschen und/oder Beschreiben der zweiten Speichereinrichtung (23) oder eine Veranlassung des Löschens und/oder des Beschreibens der zweiten Speichereinrichtung (23) durch eine externe Vorrichtung ausgeschlossen ist.

8. Vorrichtung nach Anspruch 7 dadurch gekennzeichnet, daß die Speicherung der den Programmiervorgang dokumentierenden Daten unter selbständiger und ausschließlicher Veranlassung durch das Steuergerät (20) begonnen und beendet wird.

9. Vorrichtung nach Anspruch 7, dadurch gekennzeichnet, daß die Speicherung der den Programmiervorgang dokumentierenden Daten während der Programmierung der programmierbaren Speichereinrichtung (22) erfolgt.

10. Vorrichtung nach Anspruch 7, dadurch gekennzeichnet, daß die Speicherung der den Programmiervorgang dokumentierenden Daten während des Löschens oder während des Überschreibens der ersten Speichereinrichtung (22) erfolgt.

11. Vorrichtung nach Anspruch 7, dadurch gekennzeichnet, daß die zweite Speichereinrichtung (23) für die den Programmiervorgang dokumentierenden Daten als Ringspeicher ausgebildet ist.

12. Vorrichtung nach Anspruch 11, dadurch gekennzeichnet, daß ein der zweiten Speichereinrichtung (23) für die den Programmiervorgang dokumentierenden Daten zugeordneter Adreßzähler als Modulo-Zähler ausgebildet ist.

## Claims

1. Process for the operation of a controller (20) with a first, programmable memory device (22) for storing data and programs for the operation of the controller and with a second, non-volatile memory device (23), wherein, in association with the programming of the first memory device (22), data documenting the programming operation are stored in the second memory device (23), characterized in that erasure of and/or writing to the second memory device (23) or initiation of erasure of and/or writing to the second memory device (23) by an external apparatus is precluded.

2. Process according to Claim 1, characterized in that the storage of the data documenting the programming operation is begun and ended with independent and exclusive initiation by the controller (20).

3. Process according to Claim 1, characterized in that the storage of the data documenting the programming operation is effected during the programming of the programmable memory device (22).

4. Process according to Claim 1, characterized in that the storage of the data documenting the programming operation is effected during the erasure or during the overwriting of the first memory device (22).

5. Process according to Claim 1, characterized in that the second memory device (23) for the data documenting the programming operation is designed as a circular buffer.

6. Process according to Claim 5, characterized in that an address counter assigned to the second memory device (23) for the data documenting the programming operation is designed as a modulo counter.

7. Apparatus for the operation of a controller (20) with a first, programmable memory device (22) for storing data and programs for the operation of the controller and with a second, non-volatile memory device (23), wherein, in association with the programming of the programmable memory device, data documenting the programming operation are stored in the second memory device (23), characterized in that erasure of and/or writing to the second memory device (23) or initiation of erasure of and/or writing to the second memory device (23) by an external apparatus is precluded.

8. Apparatus according to Claim 7, characterized in that the storage of the data documenting the programming operation is begun and ended with independent and exclusive initiation by the controller (20).

9. Apparatus according to Claim 7, characterized in that the storage of the data documenting the programming operation is effected during the programming of the programmable memory device (22).

10. Apparatus according to Claim 7, characterized in that the storage of the data documenting the programming operation is effected during the erasure or during the overwriting of the first memory device (22).

11. Apparatus according to Claim 7, characterized in that the second memory device (23) for the data documenting the programming operation is designed as a circular buffer.

12. Apparatus according to Claim 11, characterized in that an address counter assigned to the second memory device (23) for the data documenting the programming operation is designed as a modulo counter.

## Revendications

1. Procédé de mise en oeuvre d'un appareil de commande (20) comportant une première mémoire programmable (22) pour enregistrer des données des programmes servant au fonctionnement de l'appareil de commande ainsi qu'une seconde mémoire non fugitive (23),
partant de la programmation de la première installation de mémoire (22), on documente les données pour l'opération de programmation en les enregistrant dans la seconde mémoire (23),
caractérisé en ce que
l'effacement et/ou la description de la seconde mémoire (23) ou si une cause d'effacement et/ou de description de la seconde mémoire (23) par un dispositif externe est exclu.

2. Procédé selon la revendication 1,
caractérisé en ce que
l'enregistrement en mémoire des données documentant l'opération de programmation par une cause indépendante et exclusive a commencé par l'appareil de commande (20) et a terminé par celui-ci.

3. Procédé selon la revendication 1,
caractérisé en ce que
l'enregistrement des données documentant l'opération de programmation se fait pendant la programmation de l'installation de mémoire programmable (22).

4. Procédé selon la revendication 1,
caractérisé en ce que
l'enregistrement des données documentant l'opération de programmation se fait pendant l'effacement ou pendant la surscription de la première mémoire (22).

5. Procédé selon la revendication 1,
caractérisé en ce que
la seconde mémoire (23) est réalisée sous la forme d'une mémoire en anneau pour les données documentant la programmation.

6. Procédé selon la revendication 5,
caractérisé par
un compteur d'adresse en forme de compteur Modulo, associé à la seconde mémoire (23) pour les données documentant l'opération de programmation.

7. Dispositif pour la mise en oeuvre d'un appareil de commande (20) comprenant une première mémoire programmable (22) pour recevoir des données et des programmes de fonctionnement de l'appareil de commande et une seconde mémoire non volatile (23), et on enregistre dans la seconde mémoire (23) les données documentant l'opération de programmation, en même temps que l'on programme l'installation de mémoire programmable,
caractérisé en ce que
l'effacement et/ou l'inscription de la seconde mémoire (23) ou le déclenchement de l'effacement et/ou l'inscription de la seconde mémoire (23) par un dispositif externe est exclu.

8. Dispositif selon la revendication 7,
caractérisé en ce que
l'enregistrement des données documentant la programmation se commence et se termine par action autonome et exclusive effectuée par l'appareil de commande (20).

9. Dispositif selon la revendication 7,
caractérisé en ce que
l'enregistrement des données documentant la programmation se fait pendant la programmation de la mémoire programmable (22).

10. Dispositif selon la revendication 7,
caractérisé en ce que
l'enregistrement des données documentant l'opération de programmation se fait pendant l'effacement ou la surscription de la première mémoire (22).

11. Dispositif selon la revendication 7,
caractérisé en ce que
la seconde mémoire (23) est réalisée sous la forme d'une mémoire en anneau pour enregistrer les données documentant l'opération de programmation.

12. Dispositif selon la revendication 11,
caractérisé par
un compteur d'adresse en forme de compteur Modulo associé à la seconde mémoire (23) pour les données documentant l'opération de programmation.
